(19) Europäisches Patentamt
European Patent Office
Office européen des brevets

(11) Numéro de publication : **0 191 661**
**B1**

(12) **FASCICULE DE BREVET EUROPÉEN**

(45) Date de publication du fascicule du brevet : **09.11.88**

(21) Numéro de dépôt : **86400043.5**

(22) Date de dépôt : **09.01.86**

(51) Int. Cl.⁴ : **C 30 B 23/02**, C 30 B 29/58, C 23 C 14/28, C 23 C 14/12, B 05 D 7/24, G 02 B 6/00

# (54) Procédé de dépôt et de cristallisation d'une couche mince de matériau organique au moyen d'un faisceau d'énergie.

(30) Priorité : **17.01.85 FR 8500654**

(43) Date de publication de la demande : **20.08.86 Bulletin 86/34**

(45) Mention de la délivrance du brevet : **09.11.88 Bulletin 88/45**

(84) Etats contractants désignés : **DE GB NL**

(56) Documents cités :
**EP-A- 0 002 738**
**US-A- 4 427 723**
**JOURNAL OF POLYMER SCIENCE: PARTIE A-2, vol. 10, 1972, pages 835-845, John Wiley & Sons, Inc.; M. SATOU et al.: "Morphological study of crystals formed in films obtained by evaporation and deposition of polyethylene"**

(73) Titulaire : **Flicstein, Jean**
**12 Bld Du Temple**
**F-75011 Paris (FR)**

**Nissim, Yves**
**57 Quai de Dion Bouton**
**F-92800 Puteaux (FR)**

**Morin, Denise**
**44, Rue de Coulmiers**
**F-94130 Nogent-sur-Marne (FR)**

(72) Inventeur : **Flicstein, Jean**
**12 Bld Du Temple**
**F-75011 Paris (FR)**
Inventeur : **Nissim, Yves**
**57 Quai de Dion Bouton**
**F-92800 Puteaux (FR)**
Inventeur : **Morin, Denise**
**44, Rue de Coulmiers**
**F-94130 Nogent-sur-Marne (FR)**

(74) Mandataire : **Mongrédien, André et al**
**c/o BREVATOME 25, rue de Ponthieu**
**F-75008 Paris (FR)**

**EP 0 191 661 B1**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue St-Denis, 75001 Paris, France

**Description**

La présente invention a pour objet un procédé de dépôt et de cristallisation d'une couche mince de matériau organique au moyen d'un faisceau de particules ou d'énergie.

Elle trouve une application en particulier dans les domaines de la fabrication de composants en optique intégrée tels que des lentilles, des miroirs, des réseaux et de la fabrication de composants opto-électroniques.

En optique intégrée, l'élément de base est un guide de lumière ; il est formé d'une couche guidante prise en sandwich entre deux substrats d'indice de réfraction inférieur à celui de la couche guidante ; cette couche guidante peut être plane et d'épaisseur homogène ou bien avoir une certaine configuration (dessins, motifs). La géométrie de la couche guidante est fonction de l'utilisation ultérieure du guide de lumière.

Actuellement, plusieurs techniques sont utilisées pour fabriquer des guides de lumières de géométrie plane ou ayant un profil particulier ; elles peuvent être regroupées en deux catégories.

La première catégorie a trait à la modification en surface d'un substrat transparent généralement en verre, en silice ou en niobate de lithium. Elle concerne plus particulièrement l'obtention, dans le substrat, d'un indice de réfraction modifié grâce à une diffusion d'ions dans ledit substrat.

Cette diffusion peut être effectuée soit sous l'impulsion d'une différence de potentiel chimique, soit suite à une implantation ionique ou une diffusion thermique d'un dopant. Dans le dernier cas, la maîtrise d'un gradient d'indice ordinaire est difficile, compte tenu des profils de concentration des dopants dans le substrat.

De plus, étant donné que le nombre de dopants compatibles avec les substrats généralement utilisés est limité, les valeurs de différence d'indice que l'on peut obtenir entre la couche diffusée et le substrat sont limitées.

Avec l'implantation ionique, il est facile de maîtriser le gradient d'indice ordinaire. Cependant, cette méthode est complexe, nécessitant l'emploi de faisceaux d'ions de fortes énergies ainsi que plusieurs étapes de recuit du substrat pour guérir les dommages créées lors de l'implantation.

La seconde catégorie dont le procédé de l'invention fait partie, a trait au dépôt de couches minces sur un substrat transparent. Malheureusement, les méthodes conventionnelles de dépôt produisent souvent des couches minces de qualité optique généralement médiocre.

Par ailleurs, pour la fabrication de composants optiques intégrés et de composants opto-électroniques, on envisage de plus en plus de remplacer les matériaux généralement utilisés tels que le verre, la silice ou le niobate de lithium par des matériaux organiques, principalement pour des raisons de flexibilité des matériaux.

Les recherches de ces dernières années ont en effet montré que de nombreux matériaux organiques, sous forme cristallisée, et notamment des polymères pouvaient avoir des réponses optiques non linéaires ainsi que des réponses électro-optiques, comparables à celles des meilleurs matériaux normalement utilisés. On peut notamment se référer à l'article de J. BADAN et al, intitulé « Non Linear Organic Crystals : Theoritical Concepts, Materials, and Optical Properties » paru dans ACS Symposium séries 233, 81 (1983), pages 81-107 et à l'article de J. ZYSS intitulé « A Molecular Engineering Approach Towards the Design of Efficient Organic Crystals for Three Waves Mixing » paru dans Current Trends in Optics de 1981, pages 123-134.

Parmi ces composés organiques sous forme cristalline, on trouve un grand nombre de composés à transfert de charge intramoléculaires ayant le grand avantage de présenter une aptitude à être polarisés, donnant lieu à un comportement optiquement actif du matériau organique, comme par exemple le doublement en fréquence de l'onde lumineuse arrivant sur ledit matériau. Il est aussi possible d'obtenir avec ces matériaux organiques cristallisés une modulation de phase basée sur l'effet Pockels, compte tenu des propriétés optoélectroniques de certains de ces matériaux organiques et de la stabilité de la maille cristalline de ces matériaux.

Compte tenu de ces nouveaux matériaux, les techniques conventionnelles de dépôt d'une couche mince cristalline sur un substrat transparent, pour fabriquer un guide de lumière de géométrie plane ou ayant un dessin particulier, présentent un certain nombre d'inconvénients spécifiques.

La première technique de dépôt d'une couche mince cristalline de matériau organique connue sur un substrat est l'épitaxie sur ce substrat à partir de solutions sursaturées en matériau organique. Elle est notamment décrite dans un article de « Optical and Quantum Electronics » 7 (1975), pages 465-473 de H.P. WEBER et al. intitulé « Organic Materials for Integrated Optics ».

Cette technique qui permet d'obtenir des couches minces monocristallines de grande surface à une température avoisinant l'ambiante ne permet que difficilement la fabrication d'un système optique multicomposants, c'est-à-dire comportant plusieurs composants. Ceci tient au fait que le solvant d'épitaxie joue à la fois le rôle d'intermédiaire et celui d'impureté. En outre, la réalisation de dessins ou d'une couche ayant un profil particulier est difficile à mettre en œuvre.

La seconde méthode de dépôt d'une couche mince cristalline de matériau organique est la méthode de Langmuir-Blodgett. Elle a notamment été décrite dans un article de « Journal of Non-Cristalline Solids » 47,2 (1982), pages 159-174 de C.W. PITT intitulé « Materials and Fabrication Techniques for

Integrated Optics : organic and amorphous materials ».

Cette méthode qui permet le dépôt couche par couche d'un matériau diélectrique organique monocristallin (couches dites monomoléculaires) assure une bonne maîtrise de l'épaisseur totale de la couche de matériau organique déposée. Par ailleurs, l'indice de réfraction de ces couches organiques peut être potentiellement changé d'une manière précise permettant ainsi l'obtention de façon aisée de dessins et de guides de lumière de géométrie plane. De plus, les couches organiques obtenues peuvent diffuser la lumière, ce phénomène étant dû à la nucléation de trous, de la même dimension que la longueur d'onde de la lumière reçue par lesdites couches.

Malheureusement, plusieurs éléments contraignants réduisent les atouts majeurs de cette méthode. Le premier élément est la présence obligatoire dans la molécule du matériau organique d'un couple fonctionnel solvantophile-solvantophobe, et plus particulièrement hydrophile-hydrophobe limitant considérablement le nombre de matériaux organiques pouvant être déposé par cette méthode sur un substrat ; ceci est d'autant plus vrai si on envisage le dépôt de composés organiques ayant des réponses optiques non linéaires et/ou des réponses électro-optiques.

Par ailleurs, les conditions expérimentales de croissance de la couche de matériau organique sur le substrat sont relativement complexes. En effet, il est nécessaire d'utiliser une sous-phase, une atmosphère purifiée, un système anti-vibratile, et de contrôler de façon stricte les paramètres tels que la température et le pH de la solution, le taux de dépôt du matériau et la variation de pression du milieu ambiant.

Une troisième méthode de dépôt de couche mince cristalline d'un matériau organique connu est l'évaporation sous vide par pulvérisation cathodique. Elle est notamment décrite dans l'article de C.W. PITT cité précédemment.

Cette méthode permet difficilement de contrôler l'épaisseur de la couche déposée ainsi que de former avec cette couche des dessins. En outre, ces couches organiques déposées vieillissent mal, ce vieillissement étant lié principalement à la présence de radicaux libres projetés dans les couches minces pendant leur élaboration.

Une dernière méthode de dépôt d'une couche mince cristalline d'un matériau organique connue est l'évaporation thermique. Elle est notamment décrite dans l'article « High Purity Organic Molecular Crystal » par N. Karl dans « Cristals » n° 4 (Springer Verlag) P. 65 (1980).

Cette technique permet d'obtenir des couches cristallines de matériau organique suffisamment minces, très planes et ce, quelle que soit la nature chimique de ces matériaux. Malheureusement, les principaux inconvénients de cette technique résident dans l'impossibilité de travailler avec des matériaux organiques dont la tension de vapeur est très élevée et difficilement contrôlable, dans la nécessité de travailler dans le vide, et dans certaines difficultés pour obtenir des couches minces ayant un profil donné.

Dans cette méthode d'évaporation thermique, l'évaporation se fait généralement à partir d'un creuset ou d'une cellule de Knudsen contenant le matériau à déposer sous forme de poudre. le contrôle de l'évaporation nécessite d'amener le matériau organique à son point de fusion, et donc d'utiliser un four chaud, puis de confiner ce matériau à l'état fondu tout le temps de la croissance de celui-ci sur le substrat. Ceci risque d'entraîner la dégradation des matériaux organiques qui sont sensibles à la chaleur et la contamination du matériau fondu par le creuset compte tenu du contact entre le bain et le creuset.

La présente invention a justement pour objet un nouveau procédé permettant de déposer une couche mince de matériau organique sous forme cristalline permettant notamment de remédier aux différents inconvénients donnés ci-dessus. Ce procédé est basé sur la désorption d'un matériau organique, induite par un faisceau énergétique de particules, à température ambiante. Il permet la réalisation en une seule irradiation du dépôt et de la cristallisation d'une couche de matériau organique sur un substrat, notamment transparent.

Par « substrat » il faut comprendre un matériau unique ainsi qu'un empilement de couches de natures différentes.

De façon plus précise, l'invention a pour objet un procédé de dépôt et de cristallisation d'une couche mince de matériau organique sur un substrat comportant notamment deux faces parallèles, se caractérisant en ce qu'il consiste à disposer à proximité de l'une des faces du substrat un bloc compact constitué du matériau organique, à soumettre le bloc à travers le substrat à l'action d'un faisceau énergétique de particules de façon à désorber le matériau organique formant le bloc, le substrat étant optiquement transparent audit faisceau de particules, et à effectuer un déplacement relatif entre le substrat et le faisceau de particules afin de balayer lesdites faces du substrat, selon un trajet donné, pour permettre de déposer le matériau désorbé sur la face du substrat en regard du bloc et de cristalliser le matériau ainsi déposé sous forme quasi-cristalline.

Ce procédé de dépôt et de cristallisation permet, à l'encontre des procédés de l'art antérieur, de pouvoir être utilisé pour un grand nombre de matériaux organiques et de substrats ainsi que de pouvoir déposer des rubans ou bandes de matériaux ayant un dessin ou un profil quelconque. Il présente de plus les avantages d'une mise en œuvre simple et rapide, de pouvoir contrôler avec précision l'épaisseur de la couche mince déposée et de travailler à température ambiante.

Par ailleurs, le dépôt sous forme cristallisée d'une couche en matériau organique est obtenu sans avoir besoin de chauffer le matériau au-delà de son point de fusion, chauffage qui entraînerait sa

dégradation.

De façon avantageuse, les températures induites par l'irradiation du bloc de matériau par le faisceau de particules sont choisies de façon à être inférieures au point de fusion dudit matériau organique.

L'utilisation d'un faisceau énergétique de particules est connue pour chauffer localement la surface d'un échantillon à des températures capables d'induire une recristallisation en phase solide ou fondue de ce matériau. Il est aussi connu d'utiliser le faisceau énergétique de particules pour remplacer les sources de chauffage conventionnelles pour permettre notamment l'évaporation d'un matériau ou le frittage de céramique.

Selon un mode préféré de mise en œuvre du procédé de l'invention, le faisceau de particules est un faisceau laser qui est avantageusement continu.

Selon un autre mode préféré de mise en œuvre du procédé de l'invention, le faisceau de particules est envoyé sur les faces parallèles du substrat perpendiculairement à ces faces.

Selon un autre mode préféré de mise en œuvre du procédé de l'invention, le bloc de matériau organique est obtenu à partir d'une poudre dudit matériau comprimée à froid.

De façon avantageuse, on effectue un recuit de la couche de matériau organique déposée sur le substrat, afin d'améliorer l'état cristallin de ladite couche.

Selon un autre mode préféré de mise en œuvre du procédé de l'invention, le bloc de matériau organique présente deux faces parallèles entre elles, disposées parallèlement auxdites faces parallèles du substrat et le plus près possible de ces dernières. Une telle disposition permet notamment de travailler à l'air libre sans utiliser d'enceinte d'évaporation, le matériau organique et le substrat n'ayant pas l'occasion d'être contaminés par l'atmosphère ambiante.

Cependant, pour chasser certains gaz environnants, tels que l'oxygène, on peut envisager de disposer le substrat et le bloc de matériau organique dans une enceinte à vide.

Le procédé selon l'invention présente l'avantage de pouvoir permettre le dépôt de n'importe quel type de matériau organique selon un motif désiré. En particulier, il peut être utilisé pour déposer des matériaux polymériques dont le monomère de base est choisi parmi le styrène, le méthacrylate de méthyle, les dérivés de l'urée, de la pyrrolidine, de la paranitroaniline, de la pyridineoxyde et du dinitrobenzène.

Ces matériaux organiques peuvent avantageusement être déposés sur un substrat choisi parmi le verre, la silice, l'alumine, le silicium, l'arséniure de gallium ou tout autre semiconducteur et le polyméthacrylate de méthyle.

D'autres caractéristiques et avantages de l'invention ressortiront mieux de la description qui va suivre, donnée à titre illustratif et non limitatif, en référence aux figures annexées, dans lesquelles :

— la figure 1 représente schématiquement un dispositif permettant la mise en œuvre du procédé selon l'invention, et

— la figure 2 représente schématiquement une couche mince de matériau organique obtenue par le procédé de l'invention.

En se référant à la figure 1, le procédé de dépôt et de cristallisation d'une couche mince d'un matériau organique consiste à disposer un bloc compact 2, constitué du matériau organique à déposer, à proximité d'un substrat 4 sur lequel on désire déposer ledit matériau. Ce bloc 2, par exemple de forme parallélépipédique, comprend deux faces planes parallèles entre elles 2a et 2b. Le substrat 4, notamment aussi de forme parallélépipédique comporte deux faces planes parallèles entre elles 4a et 4b. L'une des faces planes du substrat 4, par exemple la face 4a, est située en regard de l'une des faces planes, notamment la face 2b du bloc de matériau organique 2.

De façon avantageuse, les faces parallèles 2a et 2b du bloc 2 de matériau organique sont orientées parallèlement aux deux faces parallèles 4a et 4b du substrat 4, les faces 2b et 4a en regard respectivement du bloc et du substrat étant placées le plus près possible l'une de l'autre, c'est-à-dire à proximité immédiate l'une de l'autre.

Le maintien du bloc de matériau organique 2 à proximité du substrat 4 peut par exemple être obtenu en le fixant, notamment par collage, sur une plaque-support 6 telle qu'une lame de microscope. Un tel support permet d'éviter par rapport à certains procédés de l'art antérieur, la contamination par un creuset du bloc de matériau organique ; ceci est notamment lié au fait que l'on travaille à température ambiante.

Aux deux extrémités de la plaque-support 6 peuvent être prévues des cales d'épaisseur respectivement 8 et 10 sur lesquelles vient s'appuyer la face 4a du substrat 4.

Afin d'éviter un contact direct entre le bloc de matériau 2 et le substrat 4, les cales d'épaisseur 8 et 10 doivent présenter une épaisseur légèrement supérieure à celle du bloc 2. Le maintien en position du substrat 4 sur les cales d'épaisseur 8 et 10 peut être assuré par collage, ces cales étant elles-mêmes collées sur le support 6. Le maintien en place du substrat peut aussi être assuré à l'aide d'un U de référence 12 ou bien encore à l'aide d'une pince 14.

La référence 19 portée sur la figure 1 correspond à l'ensemble formé par la plaque-support 6, le bloc 2, les cales 8 et 10 et le substrat 4, rendus solidaires les uns des autres.

Après disposition du bloc de matériau organique 2 en regard du substrat 4, le bloc de matériau 2 est soumis, à température ambiante, à l'action d'un faisceau énergétique de particules 16 qui peut être avantageusement un faisceau lumineux tel qu'un faisceau laser, par exemple continu, émis par une source laser. La longueur d'onde du faisceau laser peut être située dans l'infrarouge, le visible ou

l'ultraviolet. Ce faisceau laser 16, après avoir traversé de part en part le substrat 4, interagit avec le bloc de matériau organique 2 de façon à désorber ledit matériau. Il est avantageusement orienté suivant une direction perpendiculaire aux faces parallèles 4a et 4b du substrat 4, et donc des faces 2a et 2b du bloc 2 de matériau organique, dans le cas représenté sur la figure 1.

Pour permettre la désorption du matériau organique constituant le bloc 2, et plus précisément des molécules dudit matériau, sous l'action du faisceau de particules 16, il est nécessaire, compte tenu de l'agencement des différents éléments les uns par rapport aux autres, que le substrat 4 soit réalisé en un matériau optiquement transparent au faisceau de particules 16.

Après désorption du matériau organique constituant le bloc 2, ce matériau peut se déposer sur la face 4a du substrat 4 située en regard du bloc 2 dudit matériau organique, et en particulier en regard de la face 2b de ce dernier.

Afin d'obtenir la désorption de tout le matériau organique formant le bloc 2 et de recouvrir tout ou partie de la face 4a du substrat, on effectue un déplacement relatif entre le substrat 4 et le faisceau de particules 16, et plus précisément entre l'ensemble 19 et ledit faisceau, selon un plan xy parallèle aux deux faces parallèles 4a et 4b du substrat 4. Ce déplacement relatif entre le substrat 4 et le faisceau de particules 16 est réalisé de façon à balayer les surfaces 4a et 4b du substrat, et par conséquent la face 2b du bloc organique, selon un trajet donné permettant ainsi d'obtenir une couche mince 17 de matériau organique, comme représenté sur la figure 2, ayant la forme d'un ruban continu et de forme quelconque ou bien présentant la forme de motifs continus ou discontinus ; toute géométrie pour la couche mince 17 de matériau organique est envisageable.

Ce balayage des faces planes du substrat par le faisceau laser 16 peut être obtenu en maintenant le substrat fixe ou plus exactement l'ensemble 19, et en effectuant un balayage du faisceau. Dans le cas d'un faisceau laser, comme représenté sur la figure 1, ce balayage peut être réalisé de façon connue à l'aide de deux miroirs 22 et 24 disposés en cascade. Le miroir 22, apte à tourner, comme indiqué par la flèche A, autour d'un axe perpendiculaire au plan de la figure 1, permet d'assurer un balayage du faisceau laser 16 selon la direction x. Le miroir 24, apte à tourner, comme indiqué par la flèche B, autour d'un axe situé dans le plan de la figure 1, permet d'assurer un balayage du faisceau laser 16 suivant la direction y.

On peut aussi envisager d'effectuer le balayage des faces 4a et 4b du substrat par le faisceau laser 16 en déplaçant le substrat selon les deux directions x et y à l'aide de moyens mécaniques appropriés, bien connus de l'homme du métier, le faisceau laser 16 restant fixe.

Afin d'obtenir une bonne focalisation du faisceau de particules 16 sur le bloc 2 de matériau organique, une lentille 26 orientée parallèlement aux faces 4a et 4b du substrat peut être prévue. Elle est mobile en translation, comme représenté par la flèche T, selon une direction perpendiculaire au plan xy.

L'utilisation d'un faisceau de particules 16 énergétique permet non seulement la désorption du matériau organique formant le bloc 2, mais aussi le dépôt dudit matériau sur la face 4a du substrat 4. Il permet aussi de réaliser une cristallisation de la couche de matériau organique 17 déposée, sur la face 4a du substrat 4, sous une forme polycristalline à grains monocristallins géants (quelques millimètres) orientés suivant une direction privilégiée.

Cette cristallisation qui se fait pratiquement en même temps que la sublimation du matériau organique est l'une des principales raisons pour laquelle le procédé de l'invention est applicable à un grand nombre de matériaux organiques.

Le faisceau de particules provoque la croissance de la couche mince organique sur un site bien localisé et contrôlé évitant ainsi tous les problèmes du processus de nucléation parasite comme dans les procédés antérieurs.

Afin d'améliorer la cristallisation de la couche 17 de matériau organique déposée et en vue notamment d'obtenir une couche mince tendant vers le monocristal, il est possible d'effectuer une étape supplémentaire de recuit thermique conventionnel comme par exemple un recuit au four ou bien un recuit transitoire au moyen d'un faisceau laser ou un faisceau d'électrons.

Le contrôle de l'épaisseur de la couche mince d'un matériau organique déposée se fait en jouant sur la puissance du faisceau de particules 16, sur la vitesse de balayage des faces 4a et 4b du substrat ainsi que sur le taux d'évacuation thermique de celui-ci.

Les températures induites par l'irradiation du bloc 2 de matériau organique par le faisceau de particules 16 sont choisies de façon à être inférieures au point de fusion dudit matériau organique. De plus, le gradient thermique créé sur le substrat 4 lui-même, résultant de la traversée de celui-ci par le faisceau de particules 16, va faciliter l'obtention d'un dépôt anisotrope sur la face 4a du substrat (orientation privilégiée des grains monocristallins).

Dans le cas où l'on désire obtenir une bande continue de matériau organique ayant un profil particulier (figure 2) ou bien des motifs séparés, ce qui est particulièrement intéressant pour la fabrication de composants optiques intégrés (réseau, lentille), la largeur des rubans ou des motifs peut être contrôlée en jouant sur la dimension du faisceau de particules 16. Ceci peut être réalisé par le déplacement de la lentille 26 selon la direction T (figure 1).

La largeur des rubans de matériau organique déposés (figure 2) dépend aussi de la densité de puissance du faisceau de particules, de la vitesse de balayage des faces 4a et 4b du substrat, de la proximité du substrat et du bloc de matériau, du coefficient de collage du matériau organique sur le substrat et du taux d'évacuation thermique du substrat.

Le procédé décrit ci-dessus est essentiellement un procédé thermique. En effet, la désorption du matériau organique sous l'impact du faisceau de particules 16 de forte énergie, puis le dépôt dudit matériau sur le substrat 4 s'expliquent par un processus de transfert de l'énergie, véhiculée par le faisceau de particules 16, en énergie thermique.

Le premier processus de transfert d'énergie est un facteur limitatif du procédé, car la formation d'une paire électron-trou, par absorption d'une particule et notamment d'un photon de grande énergie par le matériau organique, avant que le transfert d'énergie ait lieu sous forme de phonons, peut produire la dégradation des molécules constituant le matériau organique. A titre d'exemple, on peut obtenir la dégradation du cycle de la pyridineoxyde sous une irradiation ultraviolette.

Autrement dit, si l'on travaille au-dessous du point de fusion du matériau organique constituant le bloc 2, un photon lumineux de grande énergie produit le même effet, c'est-à-dire la désorption du matériau ainsi que sa cristallisation sur le substrat, qu'une irradiation de photons de faible énergie transmettant directement son énergie aux phonons du matériau.

En conséquence, au-dessous de la température de fusion, le choix de la longueur d'onde du faisceau de particules dépend, entre autres, des propriétés d'absorption dudit faisceau par le matériau organique.

Le critère de choix de la longueur d'onde d'irradiation à utiliser, dépend aussi de la disposition relative du bloc de matériau 2, du substrat 4 et du faisceau de particules 16. En effet, étant donné que le faisceau de particules 16, avant d'atteindre le bloc de matériau 2, doit traverser de part en part le substrat 4, il est nécessaire de choisir une longueur d'onde appartenant au domaine de transparence du substrat.

Pour illustrer ce choix de longueur d'onde, on va donner deux exemples de mise en œuvre. Si l'on désire déposer une couche mince de 3-méthyl-4-nitropyridineoxyde de formule :

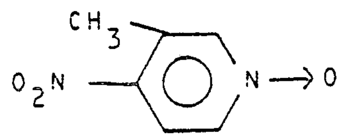

généralement connue sous l'abréviation POM, sur un substrat en verre, par exemple celui connu sous la marque VYCOR, on peut utiliser un faisceau laser à argon dont la longueur d'onde est de 514,5 nm. De même, si l'on désire déposer une couche mince de POM sur un substrat en arséniure de gallium, on peut utiliser un laser à dioxyde de carbone dont la longueur d'onde est de 10,6 µm.

Le procédé selon l'invention peut être réalisé facilement et en particulier à l'air libre, c'est-à-dire sans utilisation d'enceinte d'évaporation, à condition toutefois que le bloc 2 de matériau organique soit placé le plus près possible du substrat 4 sur lequel il doit être déposé, ce bloc et le substrat n'ayant pas alors l'occasion d'être contaminés par le milieu ambiant. Il est à noter que le dépôt du matériau organique peut se faire à l'air libre compte tenu du fait que l'on travaille à température ambiante.

Cependant, si nécessaire, l'ensemble 19, comme représenté sur la figure 1, peut être disposé à l'intérieur d'une enceinte à vide 28 afin de chasser les gaz tels que l'oxygène se trouvant au contact du bloc 2 de matériau organique et/ou du substrat 4. Un vide de $10^{-6}$ torr, c'est-à-dire de $1{,}33 \times 10^{-4}$ Pa peut être suffisant.

Le procédé selon l'invention est applicable avantageusement à un grand nombre de combinaisons bloc de matériau-substrat. En effet, en ce qui concerne le bloc 2 de matériau organique, celui-ci peut être obtenu en compactant le matériau organique que l'on désire déposer par pressage à froid d'une poudre fine et pure dudit matériau, permettant ainsi d'obtenir un bloc de matériau 2 compact, quasi-isotrope du point de vue chimique comme du point de vue physique, avec une tenue mécanique comparable à celle du monocristal du même matériau.

On peut par exemple déposer, sous forme d'une couche mince cristallisée, des matériaux organiques tels que des polymères dont le monomère est un dérivé de la pyrrolidine tel que le N-4-nitrophényl prolinol de formule :

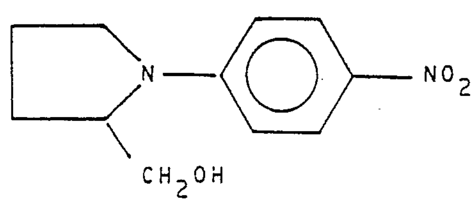

appelé NPP sous forme abrégée, ce compoé pouvant aussi être considéré comme un dérivé de la paranitroaniline ; un dérivé de la paranitroaniline tel que la 2-méthyl-4-nitroaniline appelée MNA, sous forme abrégée ; la métanitroaniline ou sous forme abrégée la mNA ; l'urée ou ses dérivés ; un dérivé de la pyridineoxyde tel que la 3-méthyl-4-nitropyridine-1-oxyde, appelée POM de façon abrégée (formule donnée précédemment), ainsi qu'un dérivé du dinitrobenzène tel que le méthyl-2,4-dinitrophényl-amino-propanoate de formule :

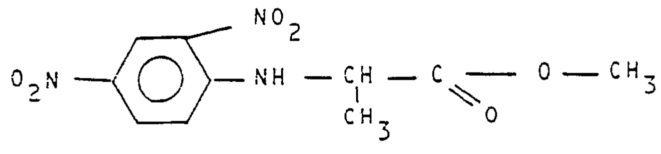

appelé MAP sous forme abrégée.

D'autres dérivés de la paranitroaniline pouvant être déposés et cristallisés selon l'invention ont notamment été décrits dans un article de « Journal of the American Chemical Society », 101 : 18, du 29 août 1979, pages 5186-5193 de H.E. SMITH et al. intitulé « Optically active amines. Spectral observations on chiral N-substituted p-nitroanilines ».

Les matériaux organiques cités ci-dessus présentent l'avantage d'avoir des réponses optiques non linéaires ainsi que des propriétés électro-optiques. Ils peuvent donc être avantageusement utilisés pour la fabrication de composants optiques intégrés et notamment de guides de lumière ainsi que pour la fabrication de composants électro-optiques.

Par ailleurs, le POM peut être utilisé comme milieu amplificateur de lumière, visible ou non.

Comme autres matériaux susceptibles d'être déposés sous forme cristalline avec le procédé de l'invention, on peut citer le polystyrène et le polyméthacrylate de méthyle, matériaux principalement utilisés pour la fabrication de guides de lumière.

Enfin, on peut citer les résines photosensibles positives ou négatives permettant la réalisation de masque pour la fabrication de circuits électroniques intégrés.

Ces différents matériaux organiques peuvent être déposés sur un substrat dont le critère de choix dépend principalement du composant optique que l'on désire obtenir. En particulier, si l'on désire intégrer sur un même substrat plusieurs composés optiques, on pourra par exemple utiliser du verre, tel que celui connu sous la marque VYCOR, de la silice, du silicium, de l'arséniure de gallium ou tout autre semiconducteur. Comme autre substrat on peut utiliser l'alumine ou le polyméthacrylate de méthyle.

Dans la fabrication de composants optiques intégrés, le choix du substrat sera tel qu'il présente un indice de réfraction inférieur à celui de la couche de matériau organique déposée afin de permettre l'utilisation de celui-ci en tant que guide de lumière ; la couche de matériau organique constitue la couche guidante du guide de lumière.

A titre d'exemple, on peut utiliser un substrat en silice ayant un indice de réfraction allant de 1,46 à 1,48 ou du verre fabriqué par la Société Corning portant la référence n° 7059 dont l'indice de réfraction varie de 1,43 à 1,59 sur lequel on dépose une couche mince de POM d'indice de réfraction allant de 1,63 à 1,78.

Le critère de choix du substrat dépend aussi des propriétés de collage du matériau organique sur ledit substrat.

On va maintenant donner des exemples détaillés de mise en œuvre du procédé de dépôt et de cristallisation d'une couche mince organique selon l'invention.

On a tout d'abord préparé des blocs compacts constitués de POM ayant la forme d'un disque de 13 mm de diamètre et de 1 mm d'épaisseur, présentant une structure polycristalline. Ces blocs ont été préparés par application d'une pression uniaxiale de 5 tonnes pendant 15 min et sous vide dans un moule à pastillage.

Ce procédé de compactage permet d'obtenir des blocs ayant deux faces planes parallèles entre elles dont la surface est parfaitement lisse.

Les blocs de POM, avant leur compactage, ont été formés à partir d'une poudre de POM, purifiée par double recristallisation et filtration sur charbon actif, puis broyée à l'aide d'une pulvérisette à billes dans un récipient en alumine, en milieu aqueux, pendant 1 h. La poudre ainsi formée a alors été séparée du milieu liquide par centrifugation puis séchée sous vide primaire dans un dessiccateur en présence d'un matériau hydrophile. Ensuite, la poudre a été placée dans le moule à pastillage, puis à nouveau séchée pendant 1 h1/2 sous vide primaire.

Ces étapes de séchage de la poudre du matériau organique permettent, en plus de son séchage, de dégazer ladite poudre permettant ainsi de l'utiliser directement dans une enceinte à vide.

L'un des blocs compacts de POM obtenu a ensuite été monté et collé sur une lame de microscope au moyen d'un ruban adhésif double face. Parallèlement aux faces planes du bloc compact de POM, a été fixé un substrat de verre, commercialisé sous le nom VYCOR, présentant la forme d'une plaquette. La fixation du substrat sur la lame de microscope a été réalisée à l'aide d'un ruban adhésif double face. Un tel montage permet de positionner à proximité immédiate l'un de l'autre le bloc de matériau organique et le substrat ; la distance séparant les deux faces planes parallèles en regard du substrat et du bloc compact de POM étaient de l'ordre de quelques dizaines de microns.

Le bloc compact de POM a ensuite été soumis à l'impact d'un faisceau laser à argon ayant une longueur d'onde de 514,5 nm. Cette irradiation a été effectuée sous une incidence de 90° avec une focalisation du faisceau laser permettant d'obtenir sur le bloc compact de POM une puissance de l'ordre de 0,9 W ; la taille du spot laser présentait un diamètre de 150 µm et la lentille de focalisation utilisée présentait une distance focale de 250 mm.

Cette irradiation a été effectuée en balayant d'un bout à l'autre les faces planes parallèles du substrat et par conséquent celles du bloc de POM, latéralement, c'est-à-dire suivant l'axe y comme représenté sur la figure 1. Ce balayage latéral permet d'effectuer une croissance continue du POM sur le substrat avec une orientation privilégiée. Il contribue à obtenir une couche mince de POM quasi-monocristalline, contenant peu de joints de grains, les grains étant orientés suivant la direction x.

La vitesse de balayage du faisceau laser était de 4,1 cm par seconde avec un taux de recouvrement entre deux passages successifs de 80 %, sur une longueur allant de 3 à 4 mm.

Dans ces conditions, on a constaté, pour une température du substrat de 25 °C, la désorption d'une quantité de POM à partir de la surface du bloc compact de matériau et le dépôt du matériau désorbé sur le substrat. Le départ de cette quantité de POM a pu être mis en évidence par pesée du bloc de POM, avant et après irradiation, et par microscopie en lumière incidente polarisée.

On a constaté que, dès le début de la désorption des molécules de POM, à partir du bloc compact de ce matériau, la surface de celui-ci se trouvait fortement recristallisée. Cette recristallisation est due au gradient de température produit par irradiation du bloc de matériau.

L'augmentation de l'effet thermique sur le bloc de matériau, soit par augmentation de la puissance incidente du faisceau laser, soit par diminution de la vitesse de balayage de celui-ci risque de dégrader le matériau organique. Dans le cas du POM, la dégradation de ce matériau est décelable par l'apparition d'une teinte brune à la surface du bloc compact dudit matériau.

Pour ce qui est de l'obtention d'une couche mince de POM sur le substrat de verre, on a effectué une analyse par microscopie en lumière polarisée incidente, expérience qui a permis de mettre en évidence des grains géants de matériau cristallisé (quelques mm). Une analyse par le diagramme de poudre avec des rayons X n'a permis d'identifier qu'un seul constituant chimique de la couche de matériau déposée sur le substrat ; ce matériau était du POM.

La même expérience que celle décrite ci-dessus a été réalisée avec un substrat en silicium. Les seules modifications apportées, par rapport à l'exemple précédent, étaient l'utilisation d'un laser à $CO_2$ ayant une longueur d'onde de 10,6 μm, la taille du spot laser qui était de 100 μm et la puissance de celui-ci qui était de 0,9 W mesurée sur bloc de POM. La couche de POM déposée et cristallisée sur le substrat en silicium était formée, comme précédemment, de grains géants monocristallins de POM.

On peut constater qu'il est possible d'obtenir un flux moléculaire de POM aussi bien en irradiant un bloc de ce matériau à l'aide d'un faisceau laser à argon, ayant une longueur d'onde de 514,5 nm ou à l'aide d'un laser à $CO_2$ ayant une longueur d'onde de 10,6 μm.

La même expérience a été effectuée avec un substrat en arséniure de gallium. Des résultats équivalents ont été trouvés en ce qui concerne la désorption des molécules de POM du bloc de matériau et sa recristallisation en surface. En revanche, le dépôt de ce matériau sur le substrat en arséniure de gallium était pratiquement inexistant.

Cette expérience permet de montrer que le rôle du coefficient « de collage » du matériau organique sur le substrat, ici du POM sur du GaAs, est important pour l'obtention d'une couche mince de matériau organique sur le substrat.

Les différentes expériences décrites ci-dessus ont été également effectuées dans le but de dessiner des lignes parallèles entre elles ; c'est-à-dire que le taux de recouvrement des passages successifs du faisceau laser était nul. Ces expériences ont permis de montrer que le bloc de matériau organique présentait en surface des grains de POM monocristallins orientés perpendiculairement à la direction du balayage latéral du faisceau laser, c'est-à-dire orientés suivant la direction x.

La largeur du trait de chaque ligne de POM est équivalente à la taille du spot du faisceau laser. Dans ces conditions, le dépôt de POM obtenu sur le substrat se présente sous forme de lignes parallèles entre elles et sous forme polycristalline.

La description donnée précédemment n'a bien entendu été donnée qu'à titre d'exemple explicatif ; toute modification de mise en œuvre du procédé selon l'invention peut être envisagée sans pour autant sortir du cadre de l'invention.

En particulier, on peut envisager de déposer plusieurs couches de matériau organique successives sur un même substrat, avec le procédé selon l'invention, à condition toutefois de tenir compte des coefficients relatifs de collage des différents matériaux pour réaliser le bloc compact de matériau organique et le dépôt de ces différents matériaux sur le substrat utilisé. En effet, un bloc compact de matériau organique formé de différentes couches des différents matériaux peut être obtenu à condition toutefois que le deuxième matériau à déposer puisse s'évaporer à une température inférieure à la température d'évaporation du premier matériau déposé et ainsi de suite.

Par ailleurs, il est possible d'effectuer le dépôt et la cristallisation d'une couche organique en utilisant un faisceau énergétique de particules autre qu'un faisceau laser. En particulier, il est possible d'utiliser un faisceau d'électrons, de rayons X, d'ions, l'emploi de tel ou tel faisceau de particules dépendant principalement du substrat utilisé. En effet, ce dernier doit être transparent au faisceau de particules utilisé, c'est-à-dire laisser passer ledit faisceau.

De même, il est possible d'utiliser un faisceau de particules pulsé à la place d'un faisceau de particules continu ; le faisceau de particules discontinu devra bien entendu apporter la même densité d'énergie par unité de surface et de temps que le faisceau continu, et le taux de répétition des impulsions choisies devra être suffisamment élevé pour assurer la continuité du recouvrement latéral en balayage.

Par ailleurs, il est possible d'envoyer le faisceau de particules suivant une direction oblique par rapport au substrat au lieu d'une direction perpendiculaire.

**Revendications**

1. Procédé de dépôt et de cristallisation d'une couche mince (17) d'un matériau organique sur un substrat (4) comportant deux faces parallèles (4a, 4b), caractérisé en ce qu'il consiste à disposer à proximité de l'une des faces (4a) du substrat (4) un bloc (2) compact constitué du matériau organique, à soumettre le bloc (2) à travers le substrat (4) à l'action d'un faisceau énergétique de particules (16) de façon à désorber le matériau organique formant le bloc (2), le substrat (4) étant optiquement transparent audit faisceau de particules (16), et à effectuer un déplacement relatif entre le substrat (4) et le faisceau de particules (16) afin de balayer lesdites faces (4a, 4b) du substrat (4), selon un trajet donné, pour permettre de déposer le matériau désorbé sur la face (4a) du substrat (4) en regard du bloc et de cristalliser le matériau ainsi déposé sous forme quasi-cristalline.

2. Procédé selon la revendication 1, caractérisé en ce que le faisceau de particules (16) est un faisceau laser.

3. Procédé selon la revendication 1 ou 2, caractérisé en ce que le faisceau de particules (16) est continu.

4. Procédé selon l'une quelconque des revendications 1 à 3, caractérisé en ce que le faisceau de particules (16) est envoyé perpendiculairement auxdites faces parallèles (4a, 4b) du substrat (4).

5. Procédé selon l'une quelconque des revendications 1 à 4, caractérisé en ce que le bloc de matériau organique (2) est obtenu à partir d'une poudre dudit matériau organique comprimée à froid.

6. Procédé selon l'une quelconque des revendications 1 à 5, caractérisé en ce que l'on effectue un recuit de la couche de matériau organique déposée (17).

7. Procédé selon l'une quelconque des revendications 1 à 6, caractérisé en ce que le substrat (4) et le bloc de matériau organique (2) sont disposés dans une enceinte à vide (28).

8. Procédé selon l'une quelconque des revendications 1 à 7, caractérisé en ce que le bloc de matériau organique (2) présente deux faces parallèles entre elles orientées parallèlement auxdites faces (4a, 4b) parallèles du substrat (4).

9. Procédé selon l'une quelconque des revendications 1 à 8, caractérisé en ce que le matériau organique est un polymère dont le monomère est choisi parmi le styrène, le méthacrylate de méthyle, les dérivés de l'urée, de la pyrrolidine, de la paranitroaniline, de la pyridineoxyde et du dinitrobenzène.

10. Procédé selon l'une quelconque des revendications 1 à 9, caractérisé en ce que le substrat (4) est choisi parmi le verre, la silice, l'alumine, le silicium, l'arséniure de gallium et le polyméthacrylate de méthyle.

11. Procédé selon l'une quelconque des revendications 1 à 10, caractérisé en ce que les températures induites par l'irradiation du bloc de matériau organique (2) par le faisceau de particules (16) sont choisies de façon à être inférieures au point de fusion dudit matériau organique.

**Claims**

1. Process for depositing and crystallizing a thin layer (17) of an organic material on a substrate (4) comprising two parallel faces (4a, 4b), characterized in that a compact block (2) formed of organic material is disposed adjacent to one of the faces (4a) of the substrate (4), the block (2) is subjected through the substrate (4) to the action of a high energy particle beam (16), so as to desorb the organic material forming the block (2), the substrate (4) being optically transparent to the particle beam (16), and a relative displacement is performed between the substrate (4) and the particle beam (16) in order to sweep said faces (4a, 4b) of substrate (4) over a given path, to enable the desorbed material to be deposited on the face (4a) of the substrate (4) opposite the block, and the material thus deposited to be crystallized in a quasicrystalline form.

2. Process according to claim 1, characterized in that the beam of particles (16) is a laser beam.

3. Process according to claim 1 or 2, characterized in that the beam of particles (16) is continuous.

4. Process according to any one of the claims 1 to 3, characterized in that the beam of particles (16) is delivered perpendicularly to the parallel faces (4a, 4b) of the substrate (4).

5. Process according to any one of the claims 1 to 4, characterized in that the block of organic material (2) is obtained from a cold-compressed powder of such organic material.

6. Process according to any one of the claims 1 to 5, characterized in that the deposited layer (17) of organic material is annealed.

7. Process according to any one of the claims 1 to 6, characterized in that the substrate (4) and the block of organic material (2) are disposed in an evacuated enclosure (28).

8. Process according to any one of the claims 1 to 7, characterized in that the block of organic material (2) has two faces which are parallel with one another and oriented in parallel with the parallel faces (4a, 4b) of the substrate (4).

9. Process according to any one of the claims 1 to 8, characterized in that the organic material is a polymer whose monomer is selected from styrene, methyl methacrylate, the derivatives of urea, pyrrolidine, paranitroaniline, pyridine oxide and dinitrobenzene.

10. Process according to any one of the claims 1 to 9, characterized in that the substrate (4) is selected from glass, silica, alumina, silicon, gallium arsenide and polymethylmethacrylate.

11. Process according to any one of the claims 1 to 10, characterized in that the temperatures induced by the irradiation of the block of organic material (2) by the beam of particles (16) are so selected as to be lower than the melting point of such organic material.

**Patentansprüche**

1. Verfahren zum Erzeugen und Kristallisieren einer dünnen Schicht (17) eines organischen Stoffs auf einer zwei parallele Oberflächen (4a, 4b) aufweisenden Unterlage (4), dadurch gekennzeichnet, daß man zunächst einer Oberfläche (4a) der Unterlage (4) einen aus dem organischen Stoff gebildeten, kompakten Block (2) anordnet, daß man den Block (2) durch die Unterlage (4) hindurch der Einwirkung einer energiereichen Teilchenstrahlung (16) aussetzt, um den den Block (2) bildenden organischen Stoff freizusetzen, wobei die Unterlage (4) für die Teilchenstrahlung (16) optisch durchlässig ist, und daß man die Unterlage (4) und den Strahl der Teilchenstrahlung (16) relativ zueinander bewegt, um die genannten Oberflächen (4a, 4b) der Unterlage (4) entsprechend einer vorgegebenen Bahn zu bestreichen, so daß sich der freigesetzte Stoff an der dem Block zugewandten Oberfläche (4a) der Unterlage (4) niederschlagen und der so niedergeschlagene Stoff in quasi-kristalliner Form kristallisieren kann.

2. Verfahren nach Anspruch 1, dadurch gekennzeichnet, daß die Teilchenstrahlung (16) ein Laserstrahl ist.

3. Verfahren nach Anspruch 1 oder 2, dadurch gekennzeichnet, daß die Teilchenstrahlung (16) kontinuierlich ist.

4. Verfahren nach einem der Ansprüche 1 bis 3, dadurch gekennzeichnet, daß die Teilchenstrahlung (16) lotrecht zu den parallelen Oberflächen (4a, 4b) der Unterlage (4) ausgerichtet wird.

5. Verfahren nach einem der Ansprüche 1 bis 4, dadurch gekennzeichnet, daß der Block aus organischem Stoff (2) durch Kaltpressen eines Pulvers des organischen Stoffs hergestellt wird.

6. Verfahren nach einem der Ansprüche 1 bis 5, dadurch gekennzeichnet, daß die niedergeschlagene Schicht (17) des organischen Stoffs, eingebrannt wird.

7. Verfahren nach einem der Ansprüche 1 bis 6, dadurch gekennzeichnet, daß das Substrat (4) und der Block (2) aus organischem Stoff in einem evakuierten Behälter (28) angeordnet werden.

8. Verfahren nach einem der Ansprüche 1 bis 7, dadurch gekennzeichnet, daß der Block (2) aus organischem Stoff zwei parallele Flächen aufweist, die untereinander parallel zu den parallelen Flächen (4a, 4b) des Substrats (4) ausgerichtet sind.

9. Verfahren nach einem der Ansprüche 1 bis 8, dadurch gekennzeichnet, daß der organische Stoff ein Polymer ist, dessen Monomer ausgewählt ist unter Styrol, Methylmetacrylat, Ureaderivaten, Pyrolydin, Paranitroanylin, Pyridinoxid und Dinitrobenzol.

10. Verfahren nach einem der Ansprüche 1 bis 9, dadurch gekennzeichnet, daß das Substrat (4) ausgewählt ist unter Glas, Siliziumoxid, Aluminiumoxid, Silizium, Galliumarsenit und Methylmethacrylat.

11. Verfahren nach einem der Ansprüche 1 bis 10, dadurch gekennzeichnet, daß die durch die Bestrahlung des Blocks (2) aus organischem Stoff mit dem Teilchenstrahl (16) hervorgerufenen Temperaturen so gewählt sind, daß sie unterhalb des Schmelzpunktes des genannten organischen Stoffs sind.

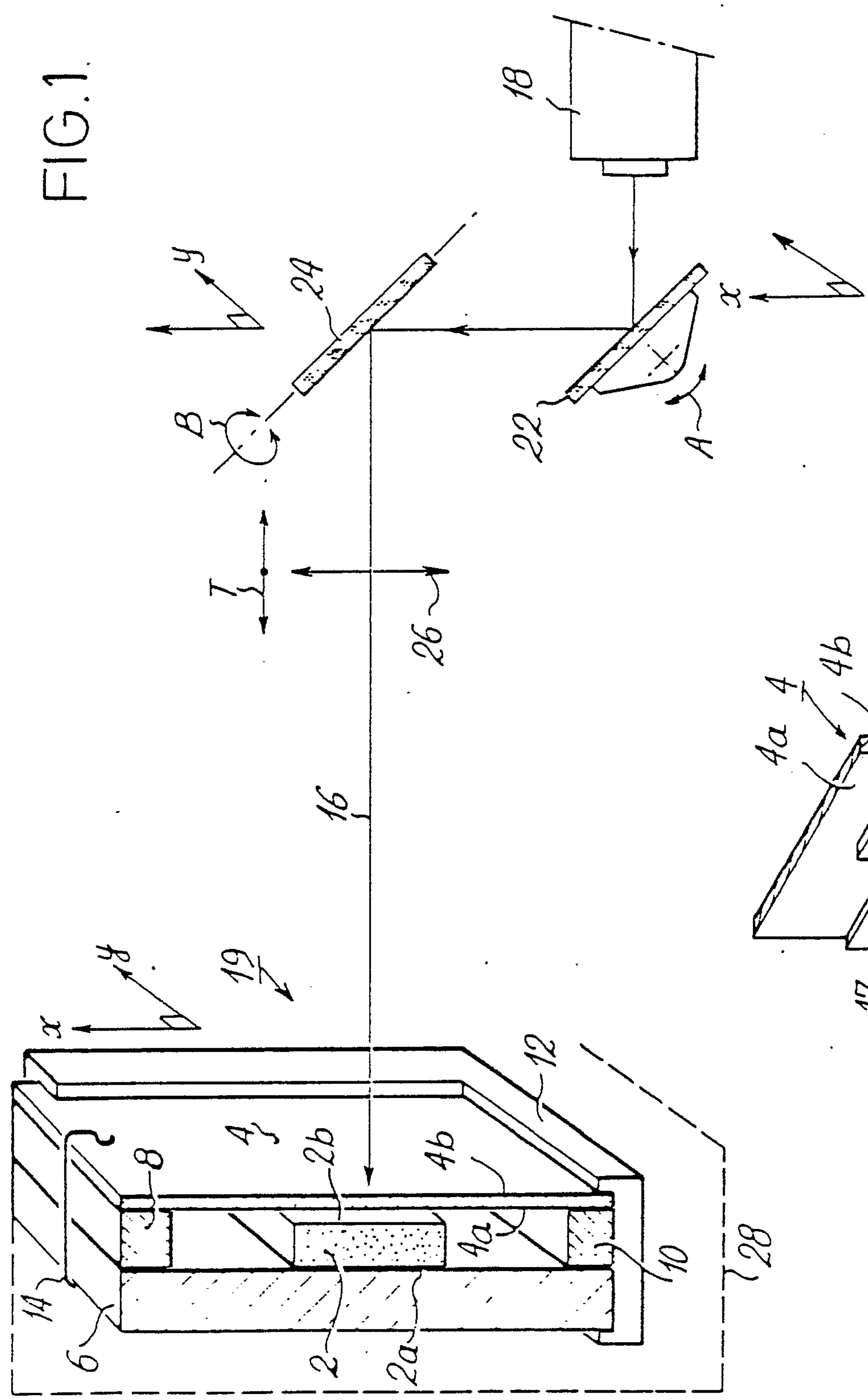


FIG.1

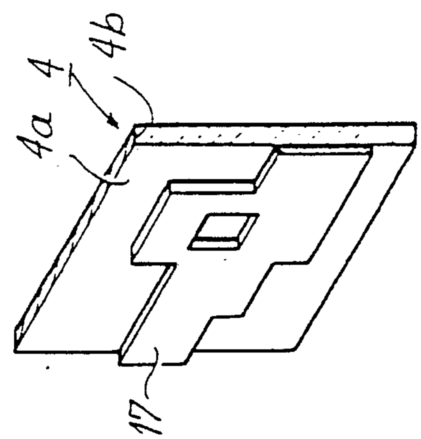


FIG.2